Europäisches Patentamt

(19) European Patent Office

Office européen des brevets

(11) **EP 0 862 224 A1**

(12) **EUROPEAN PATENT APPLICATION**

(43) Date of publication:
02.09.1998 Bulletin 1998/36

(51) Int. Cl.$^6$: **H01L 29/812**

(21) Application number: 98103155.2

(22) Date of filing: 23.02.1998

(84) Designated Contracting States:
AT BE CH DE DK ES FI FR GB GR IE IT LI LU MC
NL PT SE
Designated Extension States:
AL LT LV MK RO SI

(30) Priority: 28.02.1997 JP 46164/97

(71) Applicant: NEC CORPORATION
Tokyo (JP)

(72) Inventors:
• Chikamatsu, Kiyoshi
Minato-ku, Tokyo (JP)
• Watanabe, Toshiro
Minato-ku, Tokyo (JP)
• Inoue, Toshiaki
Minato-ku, Tokyo (JP)
• Kose, Yasushi
Minato-ku, Tokyo (JP)

(74) Representative:
Glawe, Delfs, Moll & Partner
Patentanwälte
Postfach 26 01 62
80058 München (DE)

(54) **Semiconductor device**

(57) A semiconductor device in which a plurality of transistor units are arranged in parallel on a main surface of a semiconductor substrate (1). Each of said transistor units includes: a plurality of unit cells (20) arranged in an array, each including a gate (8) formed on a main surface of the semiconductor substrate, a drain (1g) and a source (1e) formed in regions on both sides of the gate; a drain lead electrode (12) formed along one side of the unit cells arranged in an array and commonly connected with the respective drains of the unit cells in the form of comb blades; a gate lead electrode (8) formed along the other side of the unit cells arranged in an array and commonly connected with the respective gates of the unit cells in the form of comb blades; a drain pad (21) formed on one end of the drain lead electrode; and a gate pad (22) formed on one end of the gate lead electrode at a side opposite to the drain pad; wherein any one of the drain lead electrodes and the gate lead electrodes of the adjacent transistor units are disposed at least close to each other.

F I G. 1

EP 0 862 224 A1

## Description

### Background of the Invention

The present invention relates to a power amplification semiconductor device used for amplifying a super high frequency signal, and more particularly to a semiconductor device having a structure in which a plurality of drains and gates are arranged in the form of comb blades, respectively (hereinafter, referred to as "multi-finger structure").

Up to now, a power transistor that amplifies a signal of several hundreds MHz (for example, 900 MHz) has been used in a transmission stage of a portable telephone.

Since the portable telephone of this type is driven by a battery, it is desirable that the portable telephone can be used for a time as long as possible per charging. Also, in order to downsize an outline of the portable telephone and lighten the portable telephone in weight, it has been required to downsize the sizes of the battery and a heat radiating plate. However, a reduction in the size of the battery per se makes it impossible to increase a battery capacity. Therefore, the power transistor for use in the portable telephone has been required to reduce a current flowing in a circuit for power amplification and to improve the efficiency of amplification.

Under the above circumstances, in order to solve the above problems, for example, as disclosed in Japanese Utility Model Application Laid-Open No. 51-80063, there has been proposed a power transistor with a multi-finger structure which is made up of a plurality of unit cells of field effect transistor (FET) each having a drain, a gate and a source in such a manner that the drains and the gates are alternately disposed in the form of comb blades.

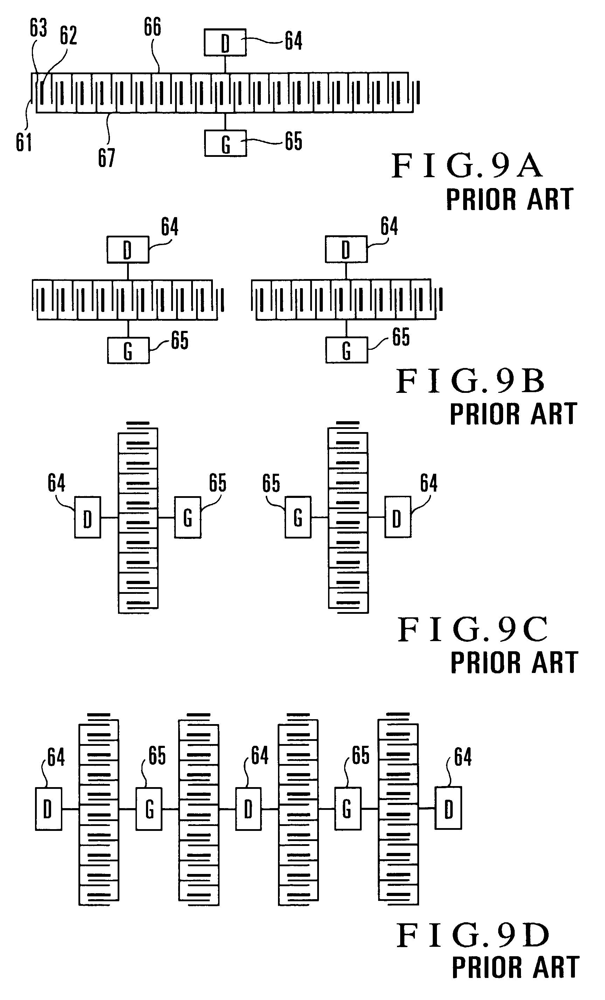

Figs. 9A to 9D are diagrams showing a layout of a conventional power transistor with the multi-finger structure. As shown in Fig. 9A, a plurality of FETs (unit cell) each having a drain 61, a source 62 and a gate 63 are disposed in an array at a given interval to constitute one unit. The respective drains 61 of each unit cell are connected to a drain pad 64 through a drain lead electrode 66 which is commonly connected to those drains 61. The respective gates 63 of each unit cell are connected to a gate pad 65 through a gate lead electrode 67 which is commonly connected to those gates 63. The drain pad 64 and the gate pad 65 are disposed in the vicinity of a center of the unit to unify a signal propagation time. In this description, a unit made of the unit cell disposed in an array, the drain lead electrode 66, the drain pad 64, the gate lead electrode 67 and the gate pad 65 is called "transistor unit".

The conventional transistor unit with the above multi-finger structure is designed to increase the number of finger electrodes or to lengthen the respective finger lengths of the drains 61, the sources 62 and the gates 63 for a high output.

In case of an MESFET (metal semiconductor FET) formed on a GaAs substrate, because a gate electrode can be made of metal low in electric resistance, the finger lengths can be lengthened. However, in the case where a gate electrode is formed on an Si substrate through an oxide film, since adhesion of the oxide film with the metal is low, a gate electrode is normally made of an electrically conductive material such as polysilicon or WSi which is larger in resistance than metal. For that reason, as the gate finger length is increased, the gate resistance is also increased, resulting in a deterioration of the high-frequency characteristic.

Therefore, the gate finger length gets shortened, and the number of finger electrodes gets increased so that the gate fingers are laterally lengthily arranged. As a result, the configuration of the chip gets slender, which leads to such a problem that a gate at an end portion of the chip produces a phase delay to degrade the characteristic.

Under the above circumstances, in order to solve the above problems, there has been proposed, as shown in Fig. 9B, a layout structure in which a transistor unit is divided into two pieces at a center thereof, and pads 64 and 65 are disposed in the divided units, respectively. Also, in order to enhance the integration of the chip, there has been proposed, as shown in Fig. 9C, a structure in which the divided units are turned by 90°, respectively and arranged. Moreover, in order to enhance the integration of the chip, there has been proposed, as shown in Fig. 9D, a structure in which the pads 64 and 65 which can be commonly used are connected to each other in such a manner that the divided units approach each other.

However, those layouts suffer from such a problem that an input-side or load-side impedance is unbalanced between the respective units from the viewpoint of the circuit structure of the device, to thereby degrade the operation characteristic. In other words, the operation is dispersed because a unit large in load impedance becomes small in current whereas a unit small in load impedance becomes large in current.

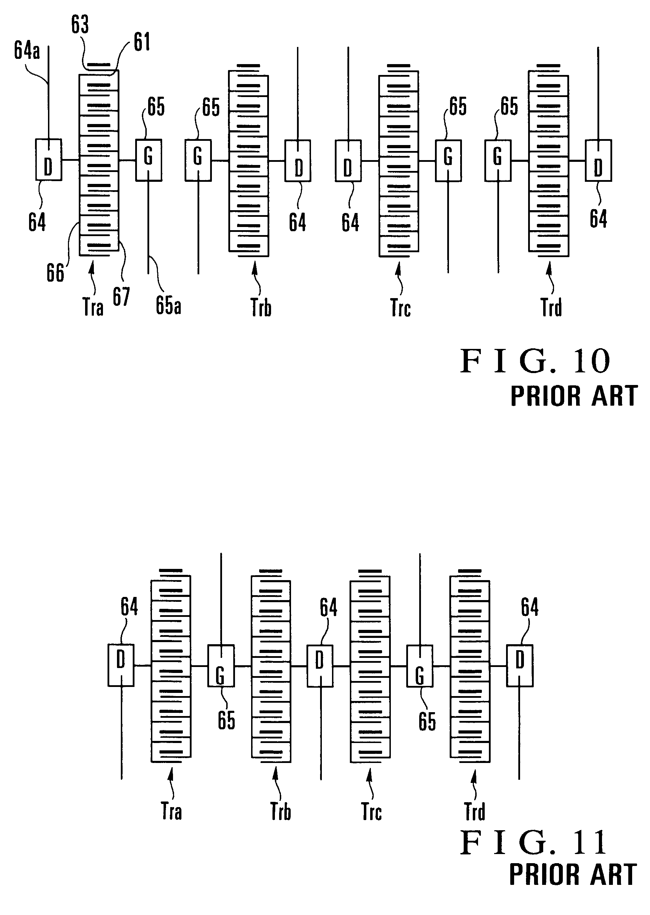

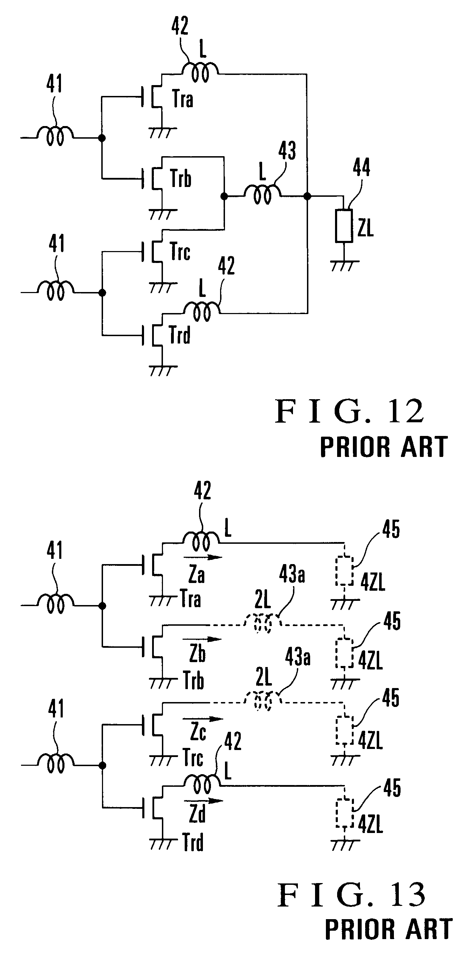

Figs. 10 and 11 are diagrams showing states in which a bonding wire is connected to each pad of units having layout structures shown in Figs. 9C and 9D, respectively. When assembling, a gate bonding wire 65a (Au or the like is used as material and 25 to 50 $\mu$m$\phi$) is connected to each of the gate pads 65, and a drain bonding wire 64a (Au or the like is used as material and 25 to 50 $\mu$m$\phi$) is connected to each of the drain pads 64. Normally, in the case where the wires are bonded to the pads, since a capillary (not shown) is used, the pad intervals cannot be narrowed more than the outline of the capillary.

In the example of Fig. 10, the respective pads 64 and 65 are arranged in an array in such a manner that they are orthogonal to the drain lead electrodes 66 and the gate lead electrodes 67 of the transistor unit. This arrangement makes the gaps between the respective transistor units broad with the result that the chip size gets large. Also, because the adjacent pads are close to each other, there arises a problem in manufacture that one pad is liable to be in contact with a bonding wire connected to another pad adjacent to the one pad when assembling.

Also, the wiring extended from the pads 64 and 65 to a lead frame (not shown) get lengthened to increase a parasitic inductance with the result that the high-frequency characteristic is degraded. Furthermore, parasitic capacitances between the gate bonding wires 65a and the drain electrodes 61 and between the drain bonding wires 64a and the gate electrodes 63 are also increased, to thereby degrade the isolation characteristic or the high-frequency characteristic.

Then, an example shown in Fig. 11 will be described with reference to an equivalent circuit shown in Fig. 12. In Fig. 12, an inductance 41 of the gate bonding wire and inductances 42 and 43 of the drain bonding wire are developed in respective transistor units Tra, Trb, Trc and Trd. In this example, a load impedance 44 of the device is ZL.

Fig. 13 is a circuit diagram showing another equivalent circuit of Fig. 12, which quantitatively represents a defect of the conventional example. Let us consider that the inductance 43 of the drain bonding wire shown in Fig. 12 is decomposed into two equivalent inductances 43a. In other words, the inductance 43 can be regarded as the two inductances 43a each having an inductance value 2L being connected in parallel.

Also, the load impedance ZL is decomposed into four equivalent impedances 45 being connected in parallel. The value of the impedance 45 is four times as large as the load impedance ZL.

In Fig. 13, assuming that impedances of the load side viewed from the transistor units Tra and Trb are Za and Zb, the following expressions are substantially satisfied:

$$Za = Zd = 4ZL + j\omega L$$

$$Zb = Zc = 4ZL + j2\omega L$$

where ZL is a load impedance, $\omega$ is $2\pi f$ and f is an operating frequency.

For that reason, there occurs a difference between the impedances of the load side viewed from the transistor units Tra, Trd and the transistor units Trb, Trc, resulting in a difference in the phases of the operating currents and the output signals of the respective transistor units. As a result, compared with a case in which all of the transistor units uniformly operate, there arises a problem that a synthetic output power of those four transistor units is reduced. This results from the fact that one drain pad 64 is commonly used for two transistor units each having a different gate pad 65.

As described above, the conventional semiconductor device having the multi-finger structure suffers from a variety of problems caused by the position of the pads.

Summary of the Invention

The present invention has been made in order to solve the above problems with the conventional devices, and therefore an object of the present invention is to provide a semiconductor device that prevents the deterioration of isolation and operates stably.

Another object of the present invention is to provide a semiconductor device excellent in amplification efficiency.

Still another object of the present invention is to provide a semiconductor device high in resistance to electrostatic breakdown.

In order to achieve the above objects, according to the present invention, there is provided a semiconductor device in which a plurality of transistor units are arranged in parallel on a main surface of a semiconductor substrate, each of the transistor units comprising: a plurality of unit cells arranged in an array, each including a gate formed on a main surface of the semiconductor substrate, a drain and a source formed in regions on both sides of the gate; a drain lead electrode formed along one side of the unit cells arranged in an array and commonly connected with the respective drains of the unit cells in the form of comb blades; a gate lead electrode formed along the other side of the unit cells arranged in an array and commonly connected with the respective gates of the unit cells in the form of comb blades; a drain pad formed on one end of the drain lead electrode; and a gate pad formed on one end of the gate lead electrode at a side opposite to the drain pad; wherein any one of the drain lead electrodes and the gate lead electrodes of the adjacent transistor units are disposed at least close to each other.

Brief Description of the Drawings

In the accompanying drawings:

Fig. 1 is a diagram showing a layout of a power transistor according to a first embodiment of the present invention;
Fig. 2 is a graph representing isolation characteristics of the layout shown in Fig. 1 and a conventional layout shown in Fig. 10;

Fig. 3 is a graph representing high-frequency operating characteristics of the power transistor having the layout shown in Fig. 1 and a conventional power transistor shown in Fig. 10;

Fig. 4 is a diagram showing a layout of a power transistor according to a second embodiment of the present invention;

Fig. 5 is an enlarged diagram showing portions surrounded by broken lines in Fig. 4;

Fig. 6 is a cross-sectional view taken along a line I-I of Fig. 5;

Fig. 7A is a front view showing a protection diode shown in Fig. 4, and Fig. 7B is a cross-sectional view taken along a line II-II of Fig. 7A;

Fig. 8A is a front view showing a conventional gate protection diode, and Fig. 8B is a cross-sectional view taken along a line III-III of Fig. 8A;

Figs. 9A to 9D are views showing the layouts of conventional transistor units having the multi-finger structure;

Fig. 10 is a diagram showing a layout of a conventional transistor unit having a multi-finger structure to which bonding wires are connected;

Fig. 11 is a diagram showing a layout of a conventional transistor unit having a multi-finger structure to which bonding wires are connected;

Fig. 12 is a diagram showing an equivalent circuit of the transistor unit shown in Fig. 11; and

Fig. 13 is a diagram showing an equivalent circuit of the transistor unit shown in Fig. 12.

Description of the Preferred Embodiments

Now, a description will be given in more detail of preferred embodiments of the present invention with reference to the accompanying drawings.

(First Embodiment)

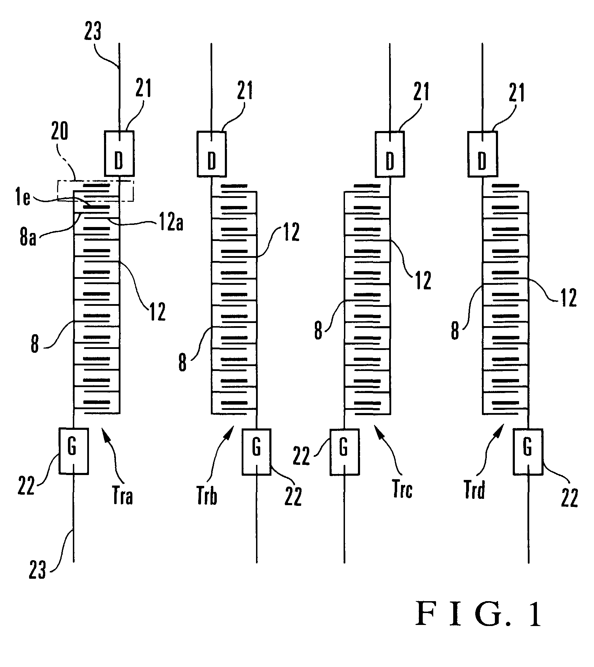

Fig. 1 is a diagram showing a layout of a power transistor according to a first embodiment of the present invention. In Fig. 1, four transistor units Tra, Trb, Trc and Trd each made up of a plurality of unit cells 20 arranged in an array are disposed on a chip in parallel to each other along a direction in which the unit cells 20 are arranged in an array. A drain pad 21 is disposed on one end side of each of the transistor units Tra, Trb, Trc and Trd in a direction of arranging the unit cells 20 in an array, and a gate pad 22 is disposed on the other end side thereof. The transistor units Tra and Trc, and the transistor units Trb and Trd have the same layout, respectively, and also the transistor units Tra and Trc are linearly symmetrical with the transistor units Trb and Trd.

Then, the structure of the transistor unit Tra will be described. The unit cell 20 is made up of a gate finger electrode 8a, a drain finger electrode 12a and a source 1e which are formed in parallel with the gate finger electrode 8a. A plurality of gate finger electrodes 8a of the plural unit cells 20 are commonly connected to a gate lead electrode 8 in the form of comb blades. A plurality of drain finger electrodes 12a of the plural unit cells 20 are commonly connected to a drain lead electrode 12 in the form of comb blades. The gate lead electrode 8 and the drain lead electrode 12 are formed in parallel with each other, between which the gate finger electrodes 8a, the drain finger electrodes 12a and the sources 1e are alternately disposed.

A gate pad 22 is formed on one end of the gate lead electrode 8, and a drain pad 21 is formed on one end of the drain lead electrode 12 opposite to the gate pad 22. The transistor unit Tra is made up of the plural unit cells 20, the gate lead electrode 8, the drain lead electrode 12, the gate pad 22 and the drain pad 21.

The source finger electrode 1e is formed between the drain finger electrode 12a and the gate finger electrode 8a and electrically connected to a semiconductor substrate through a $p^+$ implanted layer as will be described. The drain pad 21 and the gate pad 22 are electrically connected to a lead frame (not shown) through bonding wires 23, respectively. Since those bonding wires 23 are positioned in the periphery of a chip, the length of those wires can be minimized. As a result, the parasitic inductance of those wires and a parasitic capacitance between the wires and the electrodes are reduced, thereby being capable of improving the high-frequency characteristic.

Since the transistor units Tra and Trc are disposed so as to be linearly symmetrical with the transistor units Trb and Trd adjacent to those transistor units Tra and Trc, respectively, the respective drain lead electrodes 12 are disposed adjacent to each other, and the gate pad 22 and the drain pad 21 are disposed apart from each other, thereby more improving in isolation between the gate and the drain.

Since the drain pads 21 are commonly connected to a lead frame (not shown) by means of wire bonding, an impedance of a load side viewed from the drain pad 21 is identical between the respective transistor units Tra, Trb, Trc and Trd. The same is applied to the gate pad 22. Therefore, since there occurs no difference in amplitude and phase between the output signals from the respective transistor units Tra, Trb, Trc and Trd, the output can be efficiently synthesized.

Now, the performance of the present invention shown in Fig. 1 and the performance of the conventional example

EP 0 862 224 A1

will be compared.

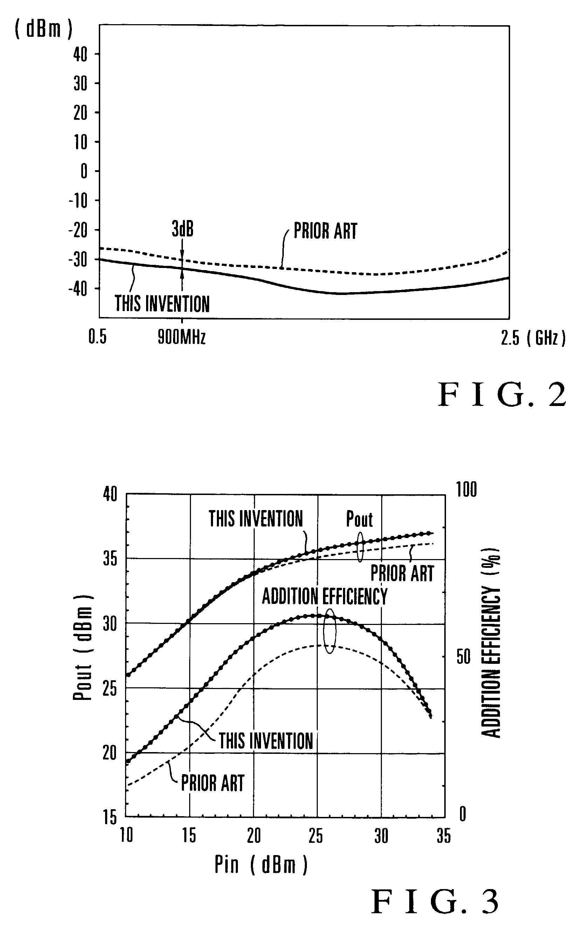

Fig. 2 is a graph representing the isolation characteristics of the layout of the present invention (Fig. 1) and the conventional layout (Fig. 10). In Fig. 2, the axis of abscissa represents a frequency f [GHz], and the axis of ordinate represents s12 which is one of s parameters of the transistor. The parameter s12 represents the magnitude of a signal returning from the output side of the transistor to the input side thereof, and means that as its numerical value is small, the returning signal is reduced more, that is, isolation is excellent.

As is apparent from Fig. 2, it is found that when the frequency f is 900 MHz, the present invention improves about 3 dB more than the conventional example. Therefore, the present invention is reduced in returning signal and very excellent in isolation.

Fig. 3 is a graph representing high-frequency amplification operating characteristics of the power transistor having the layout shown in Fig. 1 and a conventional power transistor shown in Fig. 10. In Fig. 3, the axis of abscissa represents an input power Pin [dBm], the left axis of ordinate represents an output power Pout [dBm], and the right axis of ordinate represents an addition efficiency [%]. The measurement conditions are Vds = 4.6 V and f = 900 MHz.

As is apparent from Fig. 3, it is found that the transistor of the present invention is excellent in both of Pout and addition efficiency compared to the conventional example.

For reference, specific numerical values of parts of the characteristics shown in Fig. 2 are represented in Table 1. It is found from Table 1 that the transistor of the present invention is excellent in both of Pout and addition efficiency compared to the conventional example.

[Table 1]

|  | Layout of the present invention | Conventional layout |
|---|---|---|
| Linear gain (dB) | 15.5 | 14.5 |
| Pout (dBm) * | 35.5 | 35.0 |
| Addition efficiency (%) * | 62.0 | 52.0 |
| where the above asterisked values were measured under the conditions of Pin = 25 dBm and a load of 50 Ω | | |

The addition efficiency is calculated using the following expression.

$$\text{Addition efficiency (\%)} = (\text{Pout - Pin})/(\text{Vds} \times \text{Ids}) \times 100$$

where Pout is an output power [W], Pin is an input power [W], Vds is a drain-source power voltage [V] and Ids is a drain-source power current [A].

(Second Embodiment)

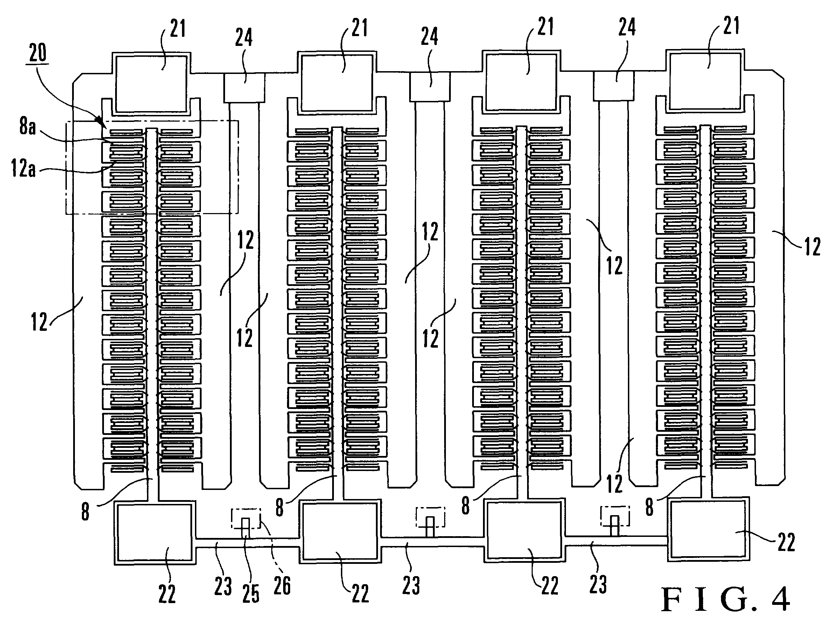

Fig. 4 is a diagram showing a layout of a power transistor according to a second embodiment of the present invention. The power transistor shown in Fig. 4 is made up of four pairs of transistor units disposed in parallel so that a drain and a gate are mutually connected between the adjacent paired transistor units. Each of the paired transistor units is made of two transistor units which are linearly symmetrically coupled, and a gate lead electrode 8 and a gate pad 22 are commonly used for each of the paired transistor units. Also, two drain lead electrodes 12 are connected to each other through a connection portion at one end side thereof, and a drain pad common to those drain lead electrodes 12 is formed on the connection portion.

Each of the transistor units is made up of a plurality of unit cells (FETs) 20 arranged in an array and each having a drain finger electrode 8a, a gate finger electrode 12a and a source alternately disposed. The drain finger electrodes 12a of the respective unit cells 20 are commonly connected in the form of comb blades to a drain lead electrode 12 formed along one side of the unit cells 20 arranged in an array. The gate finger electrodes 8a of the respective unit cells 20 are commonly connected in the form of comb blades to a gate lead electrode 8 formed along the other side of the unit cells 20 arranged in an array.

The mutually adjacent paired transistor units are designed in such a manner that the adjacent drain pads 21 are connected to each other through wirings 24 for adjacent drain pad connection, and the adjacent gate pads 22 are connected to each other through wirings 23 for adjacent gate pad connection. Those four drain pads 21 are linearly arranged through those three wirings 24, and those four gate pads 22 are linearly arranged through those three wirings

5

23.

Those wirings 23 and 24 are provided not to synthesize or distribute power but to prevent oscillation or the like, thereby stabilizing the operation. Thus, those wirings 23 and 24 are not always required. This reason is that in the case where all the transistor units uniformly operate, signals at both ends of the wirings 23 and 24 are identical in amplitude and phase, whereby the signals do not flow through the wirings 23 and 24.

Also, each of the wirings 23 is connected with a gate protection diode 26 which will be described through a wiring 25 to prevent the electrostatic breakdown of a gate oxide film. In Fig. 4, there is shown that those four transistor units are mutually connected. However, the number of transistor units mutually connected may be one or more.

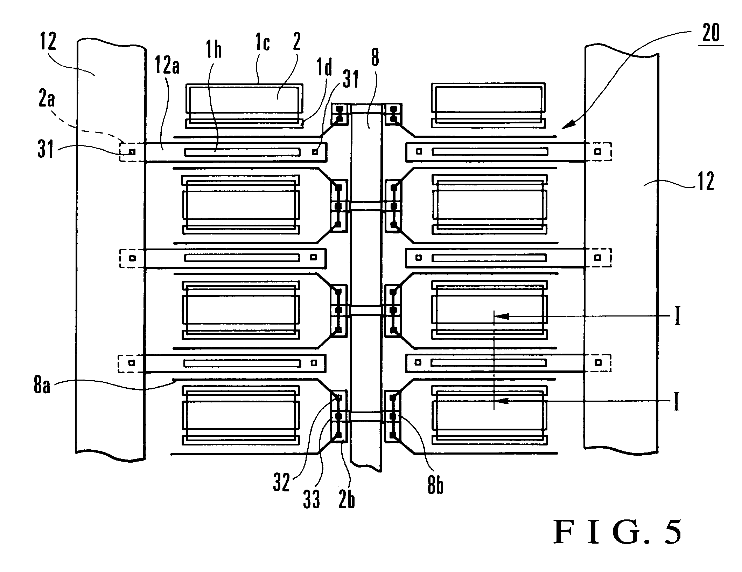

Subsequently, the detailed structure of the transistor unit will be described with reference to Fig. 5. Fig. 5 is an enlarged diagram showing a portion surrounded by a broken line in Fig. 4.

In Fig. 5, each of the drain finger electrodes (second layer aluminum wiring) 12a is connected to a drain finger electrode (first layer aluminum wiring) 2a formed below the drain finger electrode 12a in an overlapping manner through a through-hole 31. The drain finger electrode (first layer aluminum wiring) 2a is connected to a drain contact 1h common to two adjacent unit cells in a semiconductor substrate as will be described later. The drain finger electrodes 12a of the respective unit cells having the above connecting structure are commonly connected to the drain lead electrode 12.

On the other hand, those two gate finger electrodes 8a formed on the semiconductor substrate are so disposed as to be close to each other on both sides of the drain finger electrode 12a in such a manner that two gate finger electrodes 8a at a wide interval between the drain finger electrodes 12a are connected to each other at one ends thereof. In other words, the gate finger electrodes 8a are formed at unequal intervals so as to provide a narrow interval where the drain finger electrode 12a is interposed and a wide interval between the drain finger electrodes 12a.

One ends of those two gate finger electrodes 8a having the wide interval are commonly connected to the gate wiring (first layer aluminum wiring) 2b through a through-hole 32, and the gate wiring (first layer aluminum wiring) 2b is connected to a gate lead electrode projection 8b through a through-hole 33. The respective gate lead electrode projections 8b are commonly connected to the gate lead electrode 8.

If the gate lead electrode 8 is formed of the first layer aluminum wiring which is the same layer as the gate wiring (first layer aluminum wiring) 2b, the thickness of an interlayer insulation film between the gate lead electrode 8 (first layer aluminum wiring) and the semiconductor substrate 1 becomes a sum of the respective thicknesses of a gate oxide film ($SiO_2$), an insulating layer ($SiO_2$) and a BPSG (boron phosphorus silicate glass) layer. Since this thickness is very thin, the parasitic capacitance of the gate lead electrode 8 becomes large, resulting in the deterioration of the high-frequency characteristic. Therefore, it is desirable that the gate lead electrode 8 is formed of the second layer aluminum wiring.

However, when the second layer aluminum wiring and the gate finger electrodes 8a are in direct contact with each other, the aspect ratio of the contact hole becomes large, thereby being liable to cause a contact failure. In order to prevent this drawback, the gate finger electrode 8a is connected to the gate lead electrode projection 8b through the gate wiring (first layer aluminum wiring) 2b once, and the gate lead electrode projection 8b is connected to the gate lead electrode 8 which is the second layer aluminum wiring.

Also, the source contact 1d in the semiconductor substrate is connected with a just-above-source electrode (first layer aluminum wiring) 2, and the just-above-source electrode (first layer aluminum wiring) 2 is connected to the $p^+$ implanted layer 1c formed between the drain finger electrodes 12a in the semiconductor substrate.

In this embodiment, the drain lead electrode 12 is 25 $\mu$m in width and 500 $\mu$m in length, and the gate lead electrode 8 is 20 $\mu$m in width and 450 $\mu$m in length. The drain finger electrode (first layer aluminum wiring) 2a and the drain finger electrode (second layer aluminum wiring) 12 are 3.2 $\mu$m in width and 50 $\mu$m in length. The gate finger electrode 8a is 0.6 $\mu$m in width and 50 $\mu$m in length. The source contact 1d is formed by a region where phosphorus or arsenic is diffused in the semiconductor substrate with a concentration of 1E15 to 1E21 ($cm^{-3}$), and is 1.2 $\mu$m in width and 50 $\mu$m in length. The $p^+$ implanted layer 1c is formed by a region where boron is diffused in the semiconductor substrate with a concentration of 1E16 to 1E22 ($cm^{-3}$), and is 6.8 $\mu$m in width and 48 $\mu$m in length. Also, the drain pad 21 and the gate pad 22 are configured in square 100 $\mu$m in each side.

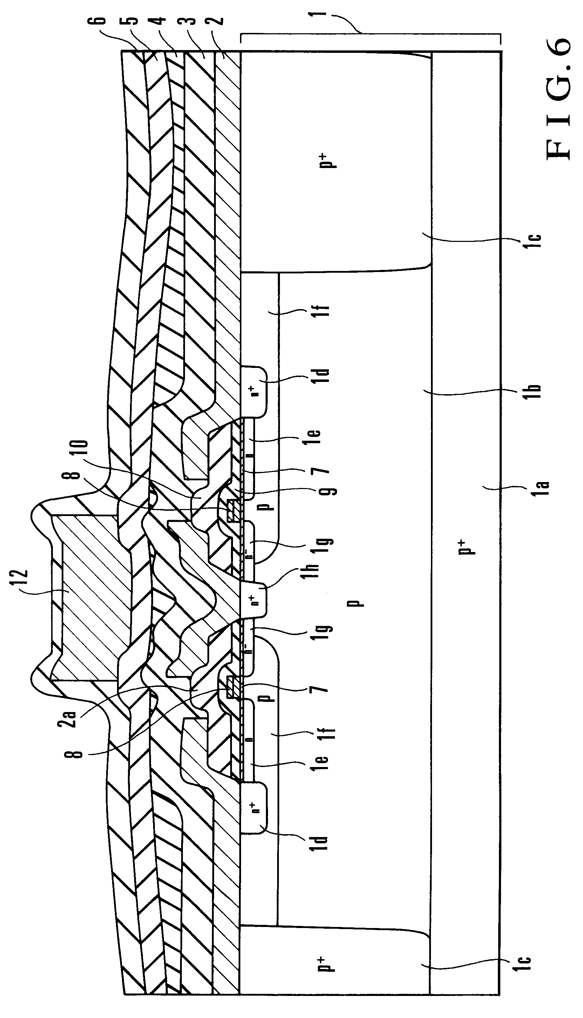

Fig. 6 is a cross-sectional view taken along a line I-I of Fig. 5. In Fig. 6, there are formed, on a $p^+$ substrate 1a that forms an Si substrate 1 which is a semiconductor substrate, a p-epitaxial layer 1b in a region corresponding to each of the drain finger electrodes 12a and a $p^+$ implanted layer 1c in a region between the respective adjacent drain finger electrodes 12a. Two p-wells 1f are formed on a surface of the p-epitaxial layer 1b at a given interval, and the gate finger electrode 8a is formed on each of the p-wells 1f through a gate oxide film 7. A source diffusion layer (n) 1e and a drain diffusion layer ($n^-$) 1g are formed on the surface of each p-well 1f on both sides of the gate finger electrode 8a in such a manner that a drain contact ($n^+$) 1h which is in contact with the respective end portions of the two opposed drain diffusion layers ($n^-$) 1g is formed on the surface of the p-epitaxial layer 1b between the p-wells 1f. On the other hand, a source contact ($n^+$) 1d is formed on the surface of each p-well 1f so as to be in contact with an end portion of the source diffusion layer (n) 1e.

The gate finger electrode 8a is formed by sequentially laminating a polycrystal Si (150 nm in thickness) and a WSi (170 nm in thickness) from a main surface side of an Si substrate 1. The widthwise section of the gate finger electrode 8a is machined to provide a sectional dimension having an electrode width about 0.6 $\mu$m. The gate finger electrode 8a and the gate insulation film 9 are covered with an $SiO_2$ layer 9 on which a BPSG layer 10 is formed.

On the Si substrate 1 on which the BPSG layer 10 is formed is selectively formed the first layer aluminum wiring layer (just-above-source electrode 2, the drain finger electrode 2a, etc.). On the first aluminum wiring layer a p-TEOS (plasma-tetraethylortho silicate) layer 3, an organic silica+inorganic silica layer 4, and a p-TEOS layer 5 are sequentially formed. The second layer aluminum wiring layer (drain finger electrode 12a, etc.) is formed on the p-TEOS layer 5 between the gate finger electrodes 8a, and a passivation nitride film (hereinafter referred to as "p nitride film") 6 is formed on the second layer aluminum wiring layer and the p-TEOS layer 5.

The first layer aluminum wiring layer is formed by sequentially laminating TiN (30 nm in thickness), Ti (50 nm in thickness), Al-Si-Cu (550 nm in thickness) and TiN (30 nm in thickness) from the Si substrate 1 side.

In the semiconductor device thus structured, upon application of a gate voltage, the gate finger electrode 8a forms an electric field in a channel formed in the p-well 1f within the Si substrate 1 through the gate oxide film 7. As a result, the conductivity of the channel between the source diffusion layer 1e and the drain diffusion layer 1g is controlled by the gate voltage.

The drain finger electrode (first layer aluminum wiring) 12 and the drain finger electrode (second layer aluminum wiring) 2a are formed in parallel with the gate finger electrode 8a as shown in Fig. 2. The drain finger electrode (first layer aluminum wiring) 2a is connected to a drain diffusion layer 1g in the Si substrate 1 through the drain contact 1h.

The source diffusion layer 1e extending from the gate finger electrode 8a to the source contact 1d in a longitudinal direction of the gate is connected to the just-above-source electrode (first layer aluminum wiring) 2 through the source contact 1d. The just-above-source electrode 2 is connected to the $p^+$ implanted layer 1c which is a high-concentration layer having a depth that reaches the $p^+$ substrate 1a.

Subsequently, the diffusion layer within the Si substrate 1 will be described. Table 2 represents diffusion species and impurity concentrations in the respective diffusion layers of Fig. 3. The respective layers are formed by ion-implanting the diffusion species listed in Table 1 with the impurity concentrations listed together.

[Table 2]

|  | Diffusion species | Impurity concentration (cm$^{-3}$) |
|---|---|---|
| source diffusion layer 1d | phosphorus or arsenic | 1E15 to 1E21 |
| source contact 1e | phosphorus or arsenic | 1E15 to 1E21 |
| p-well 1f | boron | 1E14 to 1E19 |
| drain diffusion layer 1g | phosphorus or arsenic | 1E14 to 1E21 |
| drain contact 1h | phosphorus or arsenic | 1E15 to 1E21 |
| $p^+$ implanted layer 1c | boron | 1E16 to 1E22 |
| p-epitaxial layer 1b | boron | 1E12 to 1E17 |
| $p^+$ substrate 1a | boron | 1E19 to 1E22 |

Table 3 represents the thicknesses of the respective layers in Si substrate 1.

[Table 3]

|  | Layer thickness |
|---|---|
| p nitride film 6 | 500 nm |
| p-TEOS layer 5 | 600 nm |
| organic silica + inorganic silica layer 4 | coating the layer to the degree that flattens a step, etc. |
| p-TEOS layer 3 | 800 nm |

[Table 3] (continued)

| | | Layer thickness |
|---|---|---|
| just-above-source electrode 2 | TiN | 30 nm |
| | Al-Si-Cu | 0.55 $\mu$m |
| | TiN and Ti | 80 nm |
| drain finger electrode 12 (second layer aluminum wiring layer) | | 1.6 $\mu$m |
| BPSG layer 10 | | 650 nm |
| $SiO_2$ layer 9 | | 180 nm |
| gate finger electrode 8 | WSi | 170 nm |
| | poly-Si | 150 nm |
| gate oxide film ($SiO_2$)7 | | 35 nm |

Compared with the first embodiment, this embodiment can further reduce the chip area since the gate lead electrode 8 is commonly used for two transistor units, that is, for 2-array unit cells 20. In this situation, the drain lead electrode 12 is not commonly used for the adjacent transistor unit, but individually provided. Even though the drain pad 21 is commonly used for two transistor units having the same gate lead electrode 8, there is no case in which a synthetic output power is deteriorated as in the prior art since a phase or an amplitude of the output signal are the same.

Furthermore, with the provision of a plurality of paired transistor units in parallel, a desired power can be obtained. Even in this arrangement, since the adjacent drain lead electrode 12 is not commonly used, the input impedance and the output impedance viewed from the respective paired transistor units becomes identical. Therefore, since there is no difference in amplitude and phase between the output signals of the respective paired transistor units, the output can be efficiently synthesized.

The results obtained by comparing the performance of the second embodiment shown in Fig. 4 with the performance of the conventional example were substantially identical with the results of the performance of the first embodiment shown in Figs. 2 and 3.

The arrangement similar to this embodiment has been known by Japanese Patent Application Laid-Open No. 3-289143. This publication discloses only a pair of transistor units, but does not disclose a case in which a plurality of paired transistor units are provided.

Also, the transistor disclosed in that publication is of the MESFET structure formed on a GaAs substrate so that the respective electrodes of a drain, a gate and a source must be formed on the same surface. Therefore, any electrode wirings are naturally transverse to each other, whereby the parasitic capacitance between the wirings is increased to degrade the high-frequency characteristic and the isolation characteristic.

There has been known that the source is connected to the semiconductor substrate through a contact as disclosed in Japanese Utility Model Application Laid-Open No. 51-80063 as another prior art. However, it is very difficult to form a contact connected from a front surface of the GaAs substrate to a back surface thereof. In Japanese Utility Model Application Laid-Open No. 51-80063, an opening is provided in a part of the GaAs substrate by etching, and a metal is embedded in the opening to form a contact. In the case of etching the substrate from a front surface side thereof in the existing technical level, the size of the opening becomes substantially identical with the thickness of the GaAs substrate so that the opening cannot be made small. Normally, the thickness of the GaAs substrate is about 30 $\mu$m at the thinnest, and the size of the opening becomes about 30 $\mu$m square. Compared with this embodiment, the conventional opening occupies an area about 20 times as large as the $p^+$ implanted layer of 6.8 $\mu$m square.

Conversely, in the case of etching the GaAs substrate from a back surface side thereof, although the opening on the front surface side can be reduced, an accuracy in positioning the opening and a surface pattern cannot be obtained with the result that an arrangement of the surface pattern must be designed with a margin. In any case, it was difficult to apply a fine pattern.

As another method, there is proposed a method of forming a contact by impurity diffusion as in this embodiment. However, a rate of diffusing impurities into the GaAs substrate is very low, and for example, in order to diffuse Si into a GaAs substrate of about 30 $\mu$m from a front surface thereof to a back surface, it takes 600 hours or more at 400 °C. A rise of the temperature enables the diffusion time to be reduced. However, As in the GaAs substrate is decomposed, thereby rendering it inoperative as a transistor.

As described above, in the MESFET using the GaAs substrate, it was not realistic to connect the respective source fingers to the substrate side through the contacts, respectively.

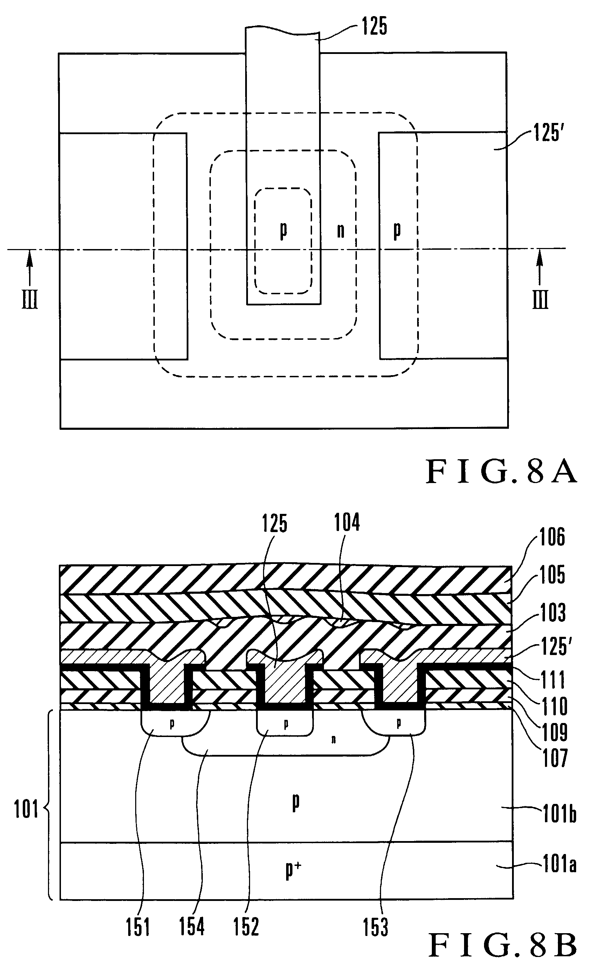

Subsequently, the gate protection diode 26 shown in Fig. 4 will be described. First, the conventional structure of the gate protection diode of this type will be described with reference to Figs. 8A and 8B.

In Figs. 8A and 8B, the conventional gate protection diode is designed in such a manner that an Si substrate 1 is made up of a p+ substrate 1a and a p-epitaxial layer 1b laminated on the p+ substrate 1a, and a p-n-p junction where two diodes are connected opposite to each other as the gate protection diodes is formed in the p-epitaxial layer 1b.

A wiring 125 led out from a gate is connected to a p-diffusion layer 152 of a diode formed in an Si substrate 101. A wiring 125' is drawn out from a source electrode in a transistor cell and formed on a main surface of the Si substrate 101. The wiring 125' is connected to a p-diffusion layer 153 of a diode. A barrier metal 111 (TiN and Ti) is formed between the wiring 125 and the Si substrate 101. Reference numeral 103 denotes a p-TEOS layer; 104, an organic silica/inorganic silica layer; 105, a p-TEOS layer; 106, a passivation nitride film; 107, a gate insulation film; and 154, an n-diffusion layer.

As mentioned above, wirings for three p-diffusion layers 151, 152 and 153 must be formed on a main surface side of the Si substrate 101, respectively. Also, a structure of an air bridge or the like must be used at a cross portion of the source wiring and the gate wiring, thereby making a wiring structure very complicated. Moreover, this makes a useless parasitic capacitance increase to degrade the high-frequency characteristic.

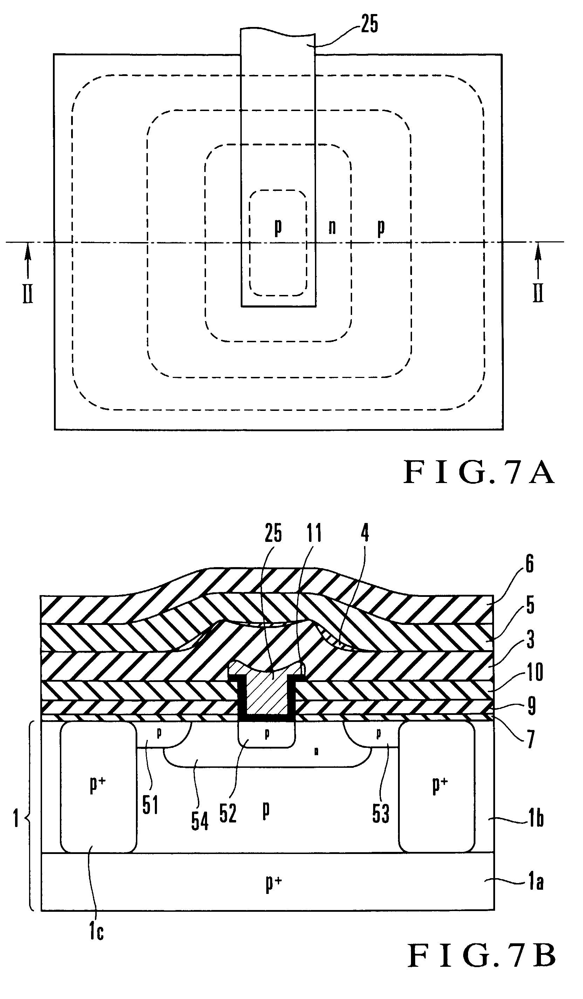

Fig. 7A is a plan view showing the gate protection diode 26 shown in Fig. 4, and Fig. 7B is a cross-sectional view taken along a line II-II of Fig. 7A. In Figs. 7A and 7B, the Si substrate 1 is made up of a p+ substrate 1a and a p-epitaxial layer 1b laminated on the p+ substrate 1a, and two p-n-p junctions made up of p-diffusion layers 51 to 53 and an n-diffusion layer 54 are formed in the p-epitaxial layer 1b as the gate protection diodes. In regions on both sides of those p-n-p junctions, a p+ implanted layer 1c is formed from the main surface of the Si substrate 1 toward the p+ substrate 1a. The p+ implanted layer 1c is connected to the p-diffusion layer 51.

A wiring 25 drawn out from the adjacent-gate-pad connection wiring 23 of Fig. 4 is connected to the p-diffusion layer 52 of a diode formed in the Si substrate 1. A barrier metal (TiN and Ti) 11 is formed between the wiring 25 and the Si substrate 1. Also, because the source electrode is connected to the p-diffusion layers 51 and 53 through the p+ substrate 1a and the p+ implanted layer 1c, there is no necessity of forming a wiring on the surface of the Si substrate, thus simplifying the wiring structure in comparison with the conventional example shown in Fig. 8. Also, since the p+ implanted layer 1c can be formed in the vicinity of the p-diffusion layer 53, static electricity can be effectively escaped to the substrate without passing through a surplus path. Furthermore, since a useless parasitic capacitance caused by a connection wiring to the source is not increased, the high-frequency characteristic is prevented from being degraded.

As was described above, according to the present invention, because the drain pad and the gate pad are arranged to be apart from each other, there can be obtained an advantage that isolation between the drain and the gate is high. In particular, the advantage is remarkable in increasing integration.

Also, because the gate interval that interposes the source gets larger than the gate interval that interposes the drain to make the gate pitch unequal, and the drain finger electrode is commonly used for two unit cells, the calorific value per unit area can be reduced more than the conventional one in increasing the integration to suppress a rise in temperature. As a result, it becomes hard to generate electro-migration of the wiring in comparison with the conventional one. Also, since the temperature of the channel portion is suppressed to a lower value, the deterioration of electronic mobility can be suppressed, and an arise in channel resistance is also suppressed. Therefore, a high-efficient power transistor can be realized without deteriorating the output of the power transistor.

Further, since the advantage obtained by using the source as a substrate is also provided, that is, the source can be mounted directly on the lead frame, no bonding wire of the source is required, thereby being capable of reducing the source inductance and improving the calorific value. Still further, since a cross-over wiring between the source wiring and the drain or gate wiring can be eliminated, the parasitic capacitance between the respective wirings can be reduced.

The foregoing description of the preferred embodiments of the invention has been presented for purposes of illustration and description. It is not intended to be exhaustive or to limit the invention to the precise form disclosed, and modifications and variations are possible in light of the above teachings or may be acquired from practice of the invention. The embodiments were chosen and described in order to explain the principles of the invention and its practical application to enable one skilled in the art to utilize the invention in various embodiments and with various modifications as are suited to the particular use contemplated. It is intended that the scope of the invention be defined by the claims appended hereto, and their equivalents.

## Claims

1. A semiconductor device in which a plurality of transistor units are arranged in parallel on a main surface of a semiconductor substrate (1), each of said transistor units characterized by comprising:

   a plurality of unit cells (20) arranged in an array, each including a gate (8) formed on a main surface of said semiconductor substrate, a drain (1g) and a source (1e) formed in regions on both sides of the gate;

a drain lead electrode (12) formed along one side of said unit cells arranged in an array and commonly connected with the respective drains of said unit cells in the form of a comb;

a gate lead electrode (8) formed along the other side of said unit cells arranged in an array and commonly connected with the respective gates of said unit cells in the form of comb blades;

a drain pad (21) formed on one end of said drain lead electrode; and

a gate pad (22) formed on one end of said gate lead electrode at a side opposite to said drain pad,

wherein any one of the drain lead electrodes and the gate lead electrodes of said adjacent transistor units are disposed at least close to each other.

2. A semiconductor device as claimed in claim 1, wherein said transistor units linearly symmetrically arranged are coupled to each other to form a pair of transistor units commonly using said gate lead electrode and said gate pad;

one ends of said drain lead electrodes are connected to each other through a connection portion; and

said drain pads are commonly used and formed on the connection portion of said drain lead electrode.

3. A semiconductor device as claimed in claim 2, wherein said plurality of paired transistor units are disposed in parallel with each other.

4. A semiconductor device as claimed in claim 3, wherein said drain pads and said gate pads of said pair of transistor units adjacent to each other are electrically connected through wirings.

5. A semiconductor device as claimed in claim 1, wherein a high-concentration layer (1c) that penetrates from a main surface of said semiconductor substrate toward a back surface thereof is provided between said paired unit cells where the drains of said unit cells adjacent to each other are disposed opposite to each other, and

the respective sources of said unit cell are connected to said high-concentration layer through a conductive layer formed on said semiconductor substrate so as to be electrically connected to said semiconductor substrate.

6. A semiconductor device as claimed in claim 1, wherein said semiconductor substrate (1a) includes a substrate into which impurities are introduced with a high concentration, an epitaxial layer (1b) formed on said substrate, and a high-concentration layer (1c) formed from the surface of said epitaxial layer up to said substrate,

the gate of said unit cell is connected to one end of a diode (26) formed in said epitaxial layer; and

the other end of said diode is electrically connected to said high-concentration layer in said substrate.

F I G. 1

11

F I G. 2

F I G. 3

F I G. 4

F I G . 5

F I G . 6

FIG.7A

FIG.7B

F I G. 8 A

F I G. 8 B

FIG.9A
PRIOR ART

FIG.9B
PRIOR ART

FIG.9C
PRIOR ART

FIG.9D
PRIOR ART

F I G. 10
**PRIOR ART**

F I G. 11
**PRIOR ART**

F I G. 12
PRIOR ART

F I G. 13
PRIOR ART

**European Patent Office**

## EUROPEAN SEARCH REPORT

Application Number

EP 98 10 3155

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 455 483 A (TEXAS INSTRUMENTS INC) 6 November 1991<br>* column 4, line 54 - column 5, line 31; figures 3,4 * | 1,4,5 | H01L29/812 |
| X | PATENT ABSTRACTS OF JAPAN<br>vol. 018, no. 008 (E-1486), 7 January 1994<br>-& JP 05 251479 A (NEC CORP), 28 September 1993,<br>* abstract * | 1-3 | |
| A | US 4 843 440 A (HUANG HO-CHUNG) 27 June 1989<br>* column 8, line 36 - column 9, line 65; figures 4-4A * | 1 | |
| A | PATENT ABSTRACTS OF JAPAN<br>vol. 096, no. 010, 31 October 1996<br>-& JP 08 162480 A (SONY CORP), 21 June 1996,<br>* abstract * | 6 | |
|  |  |  | TECHNICAL FIELDS SEARCHED (Int.Cl.6) |
|  |  |  | H01L |

The present search report has been drawn up for all claims

| Place of search | Date of completion of the search | Examiner |
|---|---|---|
| THE HAGUE | 22 June 1998 | Fransen, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document